# EUROPEAN PATENT APPLICATION

(11) **EP 2 490 516 A1**
(43) Date of publication of application: **22.08.2012**
(21) Application number: 09850407.9
(22) Date of filing: 16.10.2009
(51) Int. Cl.: H05K 7/18, H02G 3/04

(54) **CABLE DUCT, ELECTRONIC APPARATUS SYSTEM, CABLE DUCT SYSTEM, AND METHOD OF REPLACING HOUSING IN ELECTRONIC APPARATUS SYSTEM**

(71) Applicant: Fujitsu Limited, Kawasaki-shi, Kanagawa 211-8588 (JP)
(72) Inventor: YAMAMOTO, Michiyuki, Kawasaki-shi Kanagawa 211-8588 (JP)
(74) Representative: Holz, Ulrike
(86) International application number: PCT/JP2009/067932
(87) International publication number: WO 2011/045865

(57) **Abstract**

Provided are: a cable duct (20) that routes cables (9a, 9b) connected to units (7, 7) provided inside an electronic device (1a); and another cable duct (20) that is placed on another electronic device (1b) positioned adjacent to the electronic device (1a) and that routes the cables (9a, 9b) routed from the cable duct (20) of the electronic device (1a) to the electronic device (1b). Thus, it is possible to optimize the lengths of the cables connecting the electronic devices (1a, 1b) together and to arrange cables (9a to 9d) connecting the units (7, 7) while dispersing the cables in two directions.

## Description

### Field

The embodiments discussed herein are directed to a cable duct, an electronic device system, a cable duct system, and a method for replacing a housing in an electronic device system.

### Background

A computer system (hereinafter, "electronic device system") in which a plurality of electronic devices are connected together by one or more cables is conventionally known.

Such conventional electronic device systems are able to achieve a high processing capability when units housed inside a plurality of electronic devices positioned adjacent to one another are connected together by a plurality of cables so as to allow the plurality of units to collaborate.

### Citation List

### Patent Literature

Patent Literature 1: Japanese Laid-open Patent Publication No. 62-011300
Patent Literature 2: Japanese Laid-open Patent Publication No. 07-221469

### Summary

### Technical Problem

In the conventional electronic device system described above, however, all of the cables connecting together the units between the plurality of electronic devices are configured so as to use cable passages provided inside the electronic devices, regardless of the positions of the units, each of which is positioned on either an upper level or a lower level of a housing unit.

Further, all of the plurality of cables are configured so as to reach a passage provided underneath a floor by using the cable passages. Via the passage provided underneath the floor, the cables are connected to the units after being routed through the cable passage within the electronic device at the connection destination.

Consequently, within each of the electronic devices, it is preferable to provide the cable passage that is large enough to allow all the cables to go therethrough. This can be a factor that obstructs the endeavor of configuring the interior of the electronic devices with a high density. Further, the total length of the cables themselves is long, and this can make the costs of component parts, device assembly, and device installation expensive, and also, a problem arises where the transmission speed of signal data and the performance level of the entire system become low. Further, another problem arises where the ease of arranging the cables during the cable connecting task is not satisfactory, and this can be a factor that increases the man-hours of the entire work.

Accordingly, to solve the problems of the conventional examples described above, it is an object of the present invention to provide a cable duct, an electronic device system, a cable duct system, and a method for replacing a housing in an electronic device system with which it is possible to optimize the lengths of the cables connecting together the units in the electronic devices. Solution to Problem

According to an aspect of an embodiment of the invention, the aspect includes: a cable duct that routes a cable connected to a first electronic device; and another cable duct that is placed on a second electronic device positioned adjacent to the first electronic device and that routes the cable routed from the cable duct of the first electronic device to the second electronic device. Advantageous Effects of Invention

According to an aspect of the present invention, it is possible to optimize the lengths of the cables connecting together the unit provided inside the first electronic device and the unit provided inside the second electronic device positioned adjacent to the first electronic device.

### Brief Description of Drawings

FIG. 1 is a drawing of a configuration of an electronic device according to an example of a first embodiment.
FIG. 2 is a drawing of the inside of the electronic device according to the example of the first embodiment.
FIG. 3 is a drawing of a configuration of cable ducts.
FIG. 4 is a drawing of the inside of the cable ducts.
FIG. 5A is an enlarged view of a foot of one of the cable ducts.
FIG. 5B is an enlarged view of details of FIG. 5-1.
FIG. 6 is an enlarged view of a foot of one of the electronic devices.
FIG. 7 is a drawing for explaining an electronic device system in which a plurality of electronic devices are used.
FIG. 8 is a drawing of a configuration of an electronic device system according to an example of a second embodiment.
FIG. 9 is an exploded view of a configuration of a cable duct.
FIG. 10 is a perspective view of a configuration of bridges for cable ducts.
FIG. 11A is a top view of an electronic device.
FIG. 11B is a side view of the electronic device.
FIG. 11C is a cross-sectional view of the cable duct.
FIG. 12 is a flowchart for explaining a procedure in a method for replacing housings in an electronic device system.
FIG. 13A is a drawing for explaining a method for replacing electronic devices.
FIG. 13B is an enlarged view of the part P in FIG. 13A.
FIG. 14A is a drawing for explaining a method for replacing housings in the electronic device system.
FIG. 14B is another drawing for explaining the method for replacing the housings in the electronic device system.
FIG. 15 is a flowchart for explaining a procedure in a method for replacing housings in the electronic device system.
FIG. 16 is a drawing for explaining the method for replacing the housings in the electronic device system.
FIG. 17 is a flowchart for explaining a procedure in a method for replacing housings in the electronic device system.
FIG. 18A is a drawing for explaining the method for replacing the housings in the electronic device system.
FIG. 18B is another drawing for explaining the method for replacing the housings in the electronic device system.
FIG. 19 is a perspective view of a configuration in which the electronic device system according to the second embodiment is applied to a large-scale system.
FIG. 20 is a top view of a configuration of the electronic device system illustrated in FIG. 19.
FIG. 21 is a front view of a configuration of the electronic device system illustrated in FIG. 19.
FIG. 22 is a side view of a configuration of the electronic device system illustrated in FIG. 19.
FIG. 23 is a drawing of an overview of a conventional electronic device system (a first example).
FIG. 24 is a drawing of an overview of another conventional electronic device system (a second example). Description of Embodiments

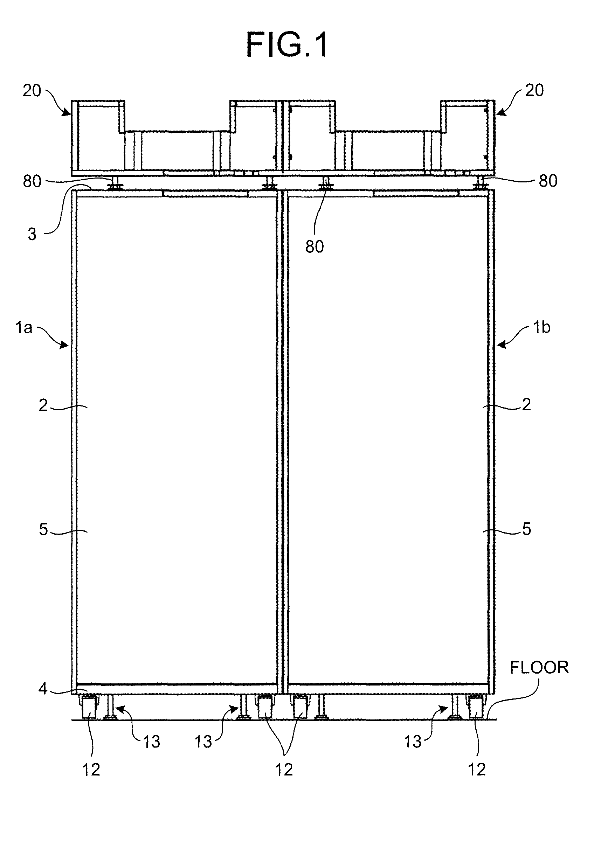

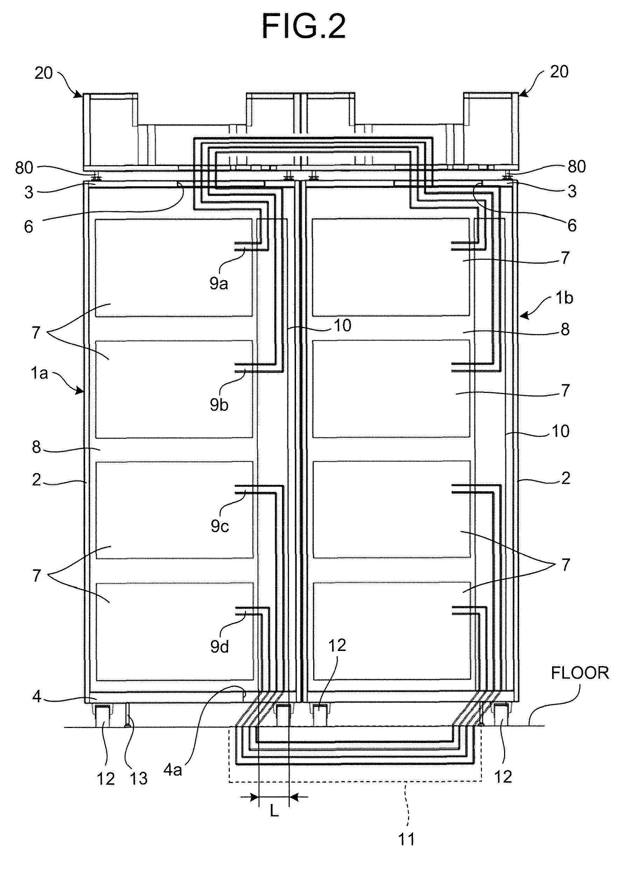

In the following sections, exemplary embodiments of a cable duct, an electronic device system, a cable duct system, and a method for replacing a housing in an electronic device system disclosed herein will be explained in detail, with reference to the accompanying drawings. FIG. 1 is a drawing of a configuration of an electronic device according to a first embodiment. FIG. 2 is a drawing of the inside of the electronic device according to the first embodiment.

An example of the first embodiment will be described below while using an example where the electronic device is a server apparatus, which is an information processing apparatus in which at least a computation processing device and a storage device are installed and in which a plurality of units are disposed in a housing. In this situation, a server rack or the like is used as the housing. The technical features disclosed herein can be applied to communication devices such as telephone switchboards and routers, as well as routers, Local Area Network devices, and the like.

Further, the technical features disclosed herein can be also applied to acoustic systems such as a Public Address (PA) system that has a printed board installed therein and is provided in a housing. Further, server units can be used as the units installed inside the electronic device.

### <An example of the first embodiment>

Depicted in FIGS. 1 and 2 is an electronic device system in which two electronic devices 1a and 1b having cable ducts 20 placed thereon are linked together, while being positioned adjacent to each other. The cable duct, the electronic device system, the cable duct system, and the method for replacing a housing in the electronic device system that are disclosed herein are not limited by the first embodiment.

As depicted in FIGS. 1 and 2, each of the electronic devices 1a and 1b is formed by a housing 2 that has a longitudinal shape as a whole and is of a console type. The housing 2 of each of the electronic devices 1a and 1b includes a top plate 3, a bottom plate 4, a front cover 5, and a rear cover (not depicted). The cable duct 20 is placed on top of the top plate 3 of each of the electronic devices 1 and 1b.

More specifically, by using the cable duct 20 placed on top of the electronic device 1a and the cable duct 20 placed on top of the electronic device 1b, it is possible to make connections of a plurality of (e.g., four in the illustrated example) cables 9a to 9d between units 7 in the electronic device 1a and units 7 in the electronic device 1b. The details of the cable ducts 20 placed on the electronic devices 1a and 1b will be explained later.

As depicted in FIG. 2, the plurality of units (e.g., four units in FIG. 2) 7 are installed inside a housing unit 8 provided within the housing 2 of each of the electronic devices 1a and 1b. The plurality of cables 9a to 9d are connected to the plurality of units 7 by using connectors (not depicted).

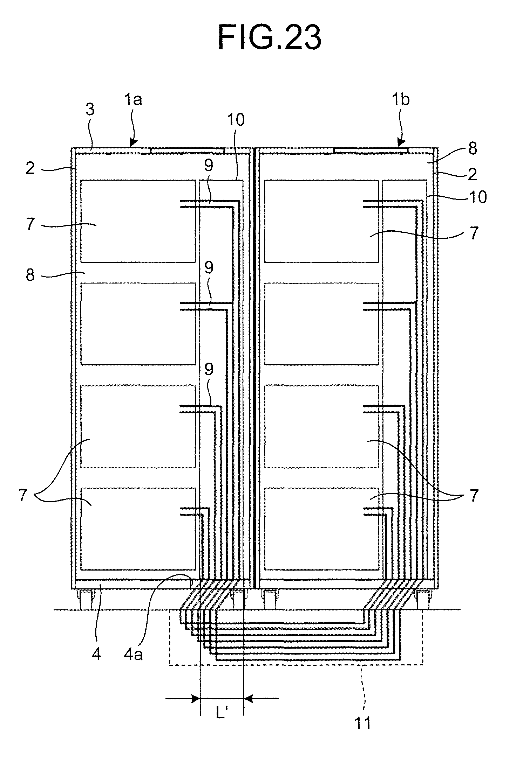

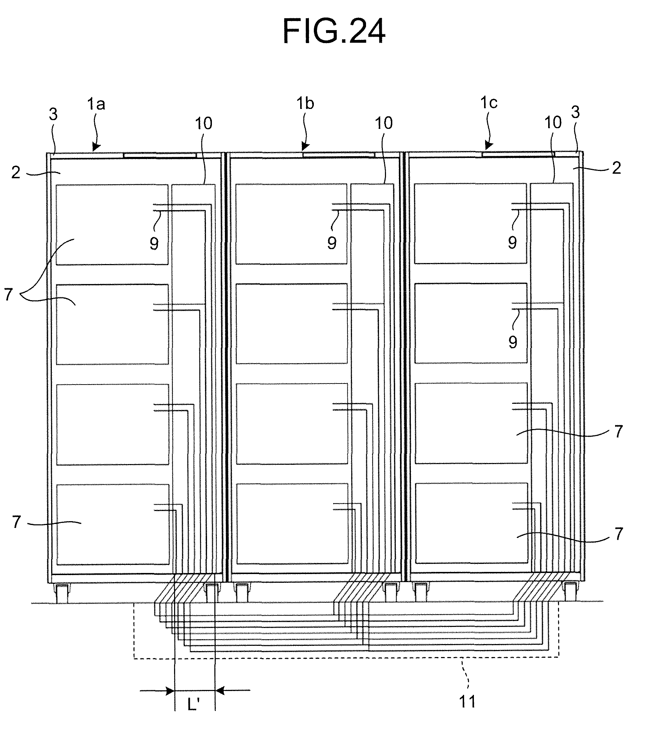

Further, a cable passage 10 that has the plurality of cables 9a to 9b going therethrough is provided on one side (e.g., the left side in FIG. 2) of the housing unit 8. To make the devices compact, the outside diameter (a dimension L) of the cable passage 10 is configured so as to have a smaller dimension than the outside diameter (a dimension L') of a cable passage 10 provided in conventional electronic devices 1a, 1b, and 1c (FIGS. 23 and 24).

Further, wheels 12 serving as casters that are used when moving the electronic devices 1a and 1b installed on a floor are fixed in predetermined positions (at the four corners) of the bottom plate 4 of each of the electronic devices 1a and 1b. In addition, raising/lowering feet 13 that are configured to adjust the height-direction position (a raised/lowered position) of the housing 2 forming each of the electronic devices 1a and 1b and are configured to fix each of the electronic devices 1a and 1b onto the floor are fixed in positions near the wheels 12.

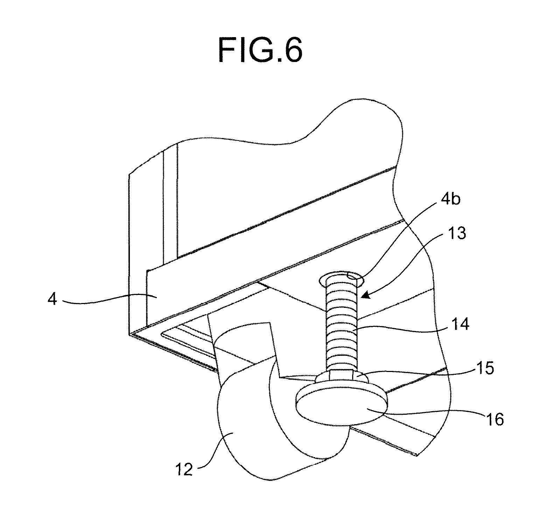

Each of the raising/lowering feet 13 includes a threaded part 14 (FIG. 6), a nut 15 to be mated with the threaded part 14, and a disc plate 16 to be in contact with the floor. The threaded part 14 of each of the raising/lowering feet 13 is screwed into a corresponding one of screw holes 4b provided in the bottom plates 4 of the cable ducts 20. The raising/lowering feet 13 function as so-called jack-up mechanisms that raise or lower the height-direction position of the electronic devices 1a and 1b with respect to the floor. By adjusting the positions of the raising/lowering nuts 15 provided in the raising/lowering feet 13, it is possible to release the fixation of the electronic devices 1a and 1b to the floor.

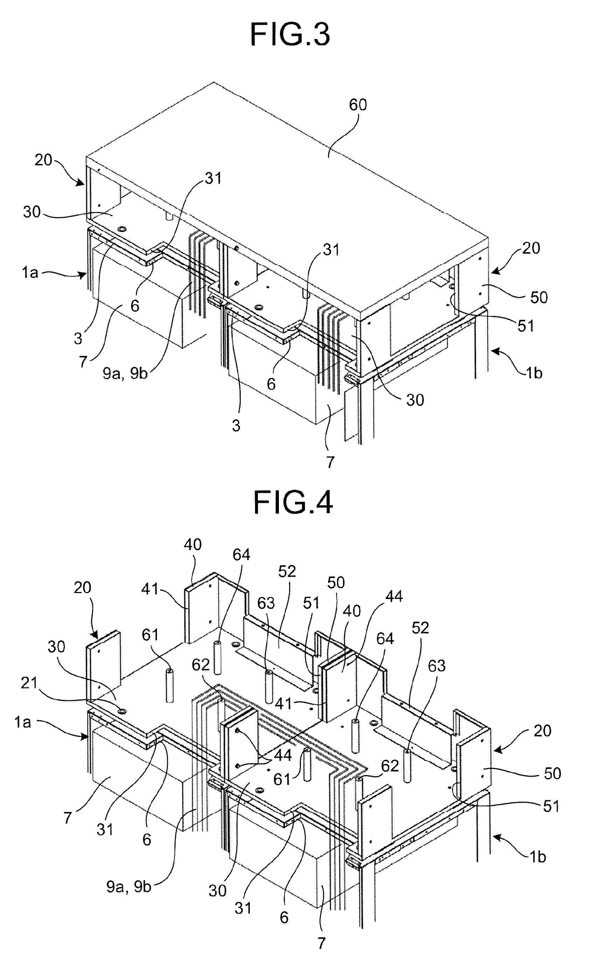

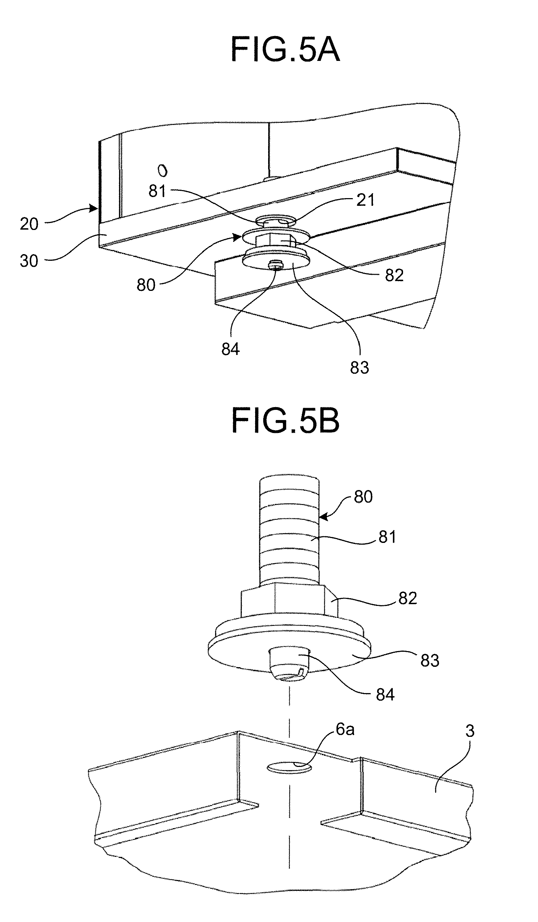

Next, details of an overall configuration of the cable ducts will be explained with reference to FIGS. 3 to 7. FIG. 3 is a drawing of a configuration of the cable ducts. FIG. 4 is a drawing of the inside of the cable ducts. FIG. 5A is an enlarged view of a foot of one of the cable ducts. FIG. 5B is an enlarged view of details of the foot depicted in FIG. 5A. FIG. 6 is an enlarged view of a foot of one of the electronic devices.

As depicted in FIGS. 3 and 4, each of the cable ducts 20 has a rectangular shape as a whole and includes: a bottom plate 30 having substantially the same size as that of each of the top plates 3 of the electronic devices 1a and 1b; a first lateral plate 40 and a second lateral plate 50 that are provided so as to stand on two sides of the bottom plate 30; and a rear plate 52.

The bottom plate 30 is positioned parallel to an installation surface of the housing 2. The first lateral plate 40 and the second lateral plate 50 are positioned perpendicular to the bottom plate 30. Further, the top plate 3 is positioned perpendicular to the first lateral plate 40 and the second lateral plate 50.

As depicted in FIGS. 3 and 4, the respective first lateral plates 40 and the respective second lateral plates 50 of the pair of (two) cable ducts 20 are joined and fixed to each other by using two linking bolts 44. Further, openings (upper faces) of the cable ducts 20 are sealed by a top face cover 60. In other words, the top face cover 60 is provided so as to close the rectangular openings that are formed at the upper faces of the housings 2 by the top plates 3, the bottom plates 30, the first lateral plates 40, and the second lateral plates 50.

A first window 41 and a second window 51 through which the cables 9a and 9b connected to the units 7 on upper levels of the electronic devices 1a and 1b are inserted are formed in each of the first lateral plates 40 and the second lateral plates 50, respectively, of the cable ducts 20. Further, a cut-out part 31 through which the cables 9a and 9b are inserted is formed on one side (the right side in FIGS. 3 and 4) of each of the bottom plates 30.

Further, a plurality of (four) pillars, which are namely a first pillar 61, a second pillar 62, a third pillar 63, and a fourth pillar 64, are provided so as to stand in predetermined positions (four places) of each of the bottom plates 30. The first to the fourth pillars 61 to 64 are provided so that the cables 9a and 9b are disposed while being arranged in an organized manner within each of the bottom plates 30 of the electronic devices 1a and 1b.

Further, feet 80 (FIG. 5A) used for adjusting the height-direction position (a raised/lowered position) of the cable duct 20 are provided in predetermined positions (at four corners) of each of the bottom plates 30 of the cable ducts 20. Each of the feet 80 includes a threaded part 81, a nut 82 that is fixed to the threaded part 81, a disc plate 83 fixed to a basal end of the threaded part 81, and a pin 84 that is fixed to substantially the center of the disc plate 83 and is used for position determining purposes. The threaded part 81 of each of the feet 80 is fixed by being screwed into one of screw holes 21 (FIG. 5A) provided in the bottom plates 30 of the cable ducts 20.

In this situation, for example, by turning the nuts 82 counter-clockwise, it is possible to raise the height-direction position of each of the cable ducts 20 with respect to the corresponding one of the electronic devices 1a and 1b, because the screwed-in amounts of the threaded parts 81 in the screw holes 21 are decreased. On the contrary, by turning the nuts 82 clockwise, it is possible to lower the height-direction position of each of the cable ducts 20 with respect to the corresponding one of the electronic devices 1a and 1b, because the screwed-in amounts of the threaded parts 81 in the screw holes 21 are increased.

Further, the pins 84 on the disc plates 83 provided in the feet 80 can be fitted into a pair of holes 6a provided in the top plates 3 of the electronic devices 1a and 1b. Thus, by fitting the pins 84 of the feet 80 of the cable ducts 20 into the holes 6a (FIG. 5B) provided in the top plates 3 of the electronic devices 1a and 1b, it is possible to place and join the cable ducts 20 to the top of the electronic devices 1a and 1b.

As depicted in FIGS. 2 to 4, the cables 9a and 9b connected to the units 7 positioned on the upper levels of the housing unit 8 of the electronic device 1a go through an insertion hole 6 provided in the top plate 3 of the electronic device 1a. Also, the cables 9a and 9b are routed through the cut-out part 31 in the bottom plate 30 of the cable duct 20 and go via the first pillar 61 and the second pillar 62. Also, the cables 9a and 9b go from the second pillar 62 and the third pillar 63 to go through the windows 41 and 51 formed in the first and the second lateral plates 40 and 50.

In other words, the cables 9a and 9b from the electronic device 1a routed through the cut-out part 31 formed in the bottom plate 30 of the electronic device 1a are routed between the first pillar 61 and the second pillar 62 and can be inserted either through the first window 41 after being routed between the second pillar 62 and the third pillar 63 or through the second window 51 after being routed between the first pillar 61 and the fourth pillar 64.

Alternatively, another arrangement is acceptable in which the cables 9a and 9b are routed through the cut-out part 31 in the bottom plate 30 of the cable duct 20 and go via the first pillar 61 and the second pillar 62 so as to go from the first pillar 61 and the fourth pillar 64 to go through the first and the second windows 41 and 51 formed in the first and the second lateral plates 40 and 50.

Further, the cables 9a and 9b routed through the first and the second windows 41 and 51 formed in the first and the second lateral plates 40 and 50 go via the cut-out part 31 formed in the bottom plate 30 of the electronic device 1b and go through an insertion hole 6 provided in the top plate 3 of the electronic device 1b. Thus, the cables 9a and 9b can be connected to the units 7 positioned on the upper levels of the housing unit 8 of the electronic device 1b.

In contrast, the cables 9c and 9d (FIG. 2) connected to the units 7 positioned on lower levels of the electronic device 1a go through the inside of the cable passage 10 and go through a passage 11 provided in a space underneath the floor through an insertion hole 4a provided in the bottom plate 4. Further, the cables 9c and 9d (FIG. 2) drawn from the passage 11 underneath the floor go via the cable passage 10 of the electronic device 1b so as to be connected to the plurality of units 7 positioned on lower levels of the housing unit 8 of the electronic device 1b.

As explained above, the electronic device system according to the first embodiment includes the cable duct 20 that routes the cables 9a and 9b connected to the units 7 positioned on the upper levels of the electronic device 1a. Further, the electronic device system also includes the cable duct 20 that is placed on the electronic device 1b positioned adjacent to the electronic device 1a and that routes the cables 9a and 9b routed from the cable duct 20 of the electronic device 1a to the electronic device 1b.

With these arrangements, it is possible to arrange the cables 9a and 9d connected to the units 7 positioned on the upper levels and the lower levels of the electronic devices 1a and 1b in such a manner that the cables are dispersed into two directions (i.e., the upper side and the lower side), instead of being bundled together. As a result, it is possible to efficiently connect the electronic devices 1a and 1b together by using an optimized length of cables.

Further, as explained above, it is possible to arrange the cables 9a to 9d connected to the units 7 in such a manner that the cables are dispersed into the two directions. As a result, it is possible to configure the width (the dimension L) of each of the cable passages 10 provided inside the electronic devices 1a and 1b so as to be smaller than (approximately a half) the width (the dimension L') of each of the conventional cable passages 10 (FIGS. 23 and 24). Also, it is possible to configure the length of the cables connecting the units 7 of the electronic devices 1a and 1b so as to be shorter than (approximately a half) the length of the cables used in the conventional example.

In other words, it is possible to install electronic component parts such as the units 7 in the electronic devices 1a and 1b with a high density and to make the housings compact. Further, because it is possible to make compact the housings 2 that form the electronic devices 1a and 1b, it is possible to shorten the cable lengths used in the cable connections between the plurality of electronic devices 1a and 1b. Consequently, it is easier to structure a large-scale server system having a high capability. As a result, it is possible to make the density of the interior of each of the electronic devices 1a and 1b higher and to significantly reduce the costs by reducing the component parts used in the cable passages 10 and the cables themselves.

### <An electronic device system in which a plurality of electronic devices are used>

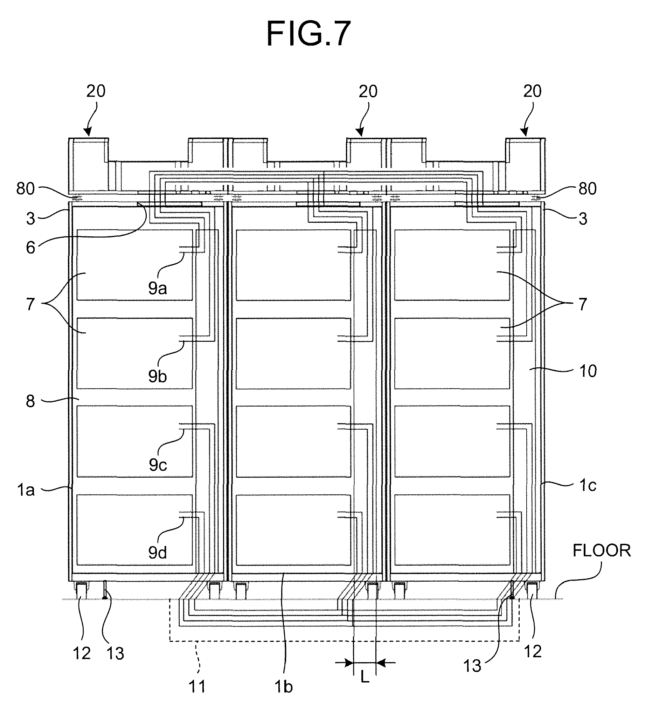

Next, an electronic device system in which a plurality of electronic devices are used will be explained, with reference to FIG. 7. Depicted in FIG. 7 is an electronic device system in which three electronic devices 1a to 1c having cable ducts 20 placed thereon are linked together, while being positioned adjacent to one another.

In the following sections, an example will be explained in which an electronic device system is structured with the plurality of (e.g., three in the illustrated example) electronic devices 1a to 1c having the cable ducts 20 placed thereon. In the electronic device system depicted in FIG. 7, some of the constituent elements that are common to the electronic devices 1a and 1b in FIG. 2 and the housings 2 of the electronic devices 1a to 1c will be referred to by using the same reference characters, and the detailed explanation thereof will be omitted.

Specifically, as depicted in FIG. 7, the cable duct 20 is placed on top of the top plate 3 of each of the electronic devices 1a to 1c. Further, by using connectors (not depicted), the cables 9a to 9d are connected to the units 7 positioned on the upper levels of the housing unit 8 provided within the housing 2 of each of the electronic devices 1a to 1c.

Further, the cables 9a and 9b going through the insertion hole 6 provided in the top plate 3 of each of the electronic devices 1a to 1c are routed through the cable ducts 20 placed on top of the electronic devices 1a to 1c so as to connect units 7 together that are positioned on upper levels of the electronic devices 1a to 1c.

As explained above, according to the first embodiment, even in the situation where the plurality of electronic devices are installed, the cable duct 20 is placed on top of each of the plurality of (e.g., three in the illustrated example) electronic devices 1a to 1c. With this arrangement, it is possible to structure the electronic device system in which the plurality of electronic devices 1a to 1c are connected together by the cables 9a to 9d.

As explained above, even in the situation where the three electronic devices 1a to 1c are installed so as to be positioned adjacent to one another, it is possible to arrange the cables 9a to 9d connected to the units 7 in such a manner that the cables are dispersed into the two directions, by using the cable ducts 20a to 20c placed on top of the electronic devices 1a to 1c. As a result, it is possible to shorten the cable lengths (approximately to a half) compared to the conventional example. Consequently, it is possible to make the density of the interior of each of the electronic devices 1a to 1c higher and to significantly reduce the costs by reducing the component parts.

### <An example of a second embodiment>

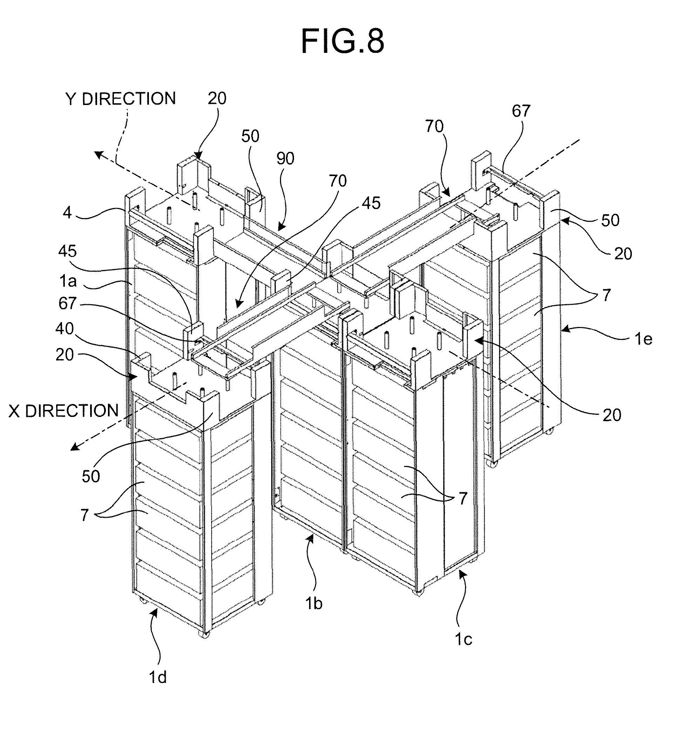

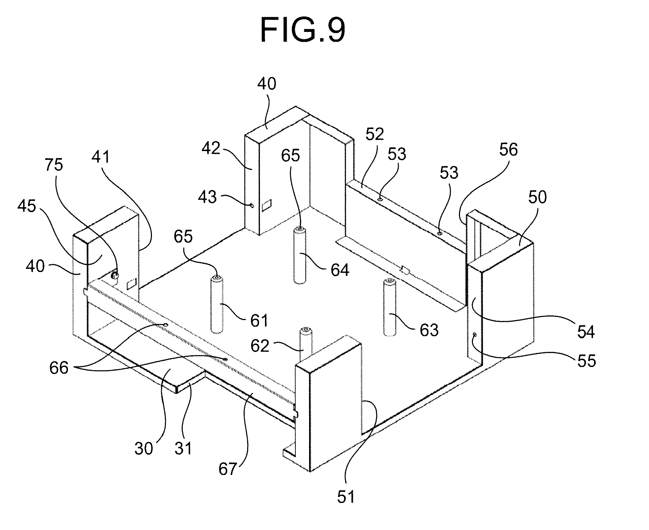

Next, an electronic device system according to an example of a second embodiment will be explained. FIG. 8 is a drawing of a configuration of an electronic device system according to the example of the second embodiment. FIG. 9 is a drawing of a configuration of a cable duct.

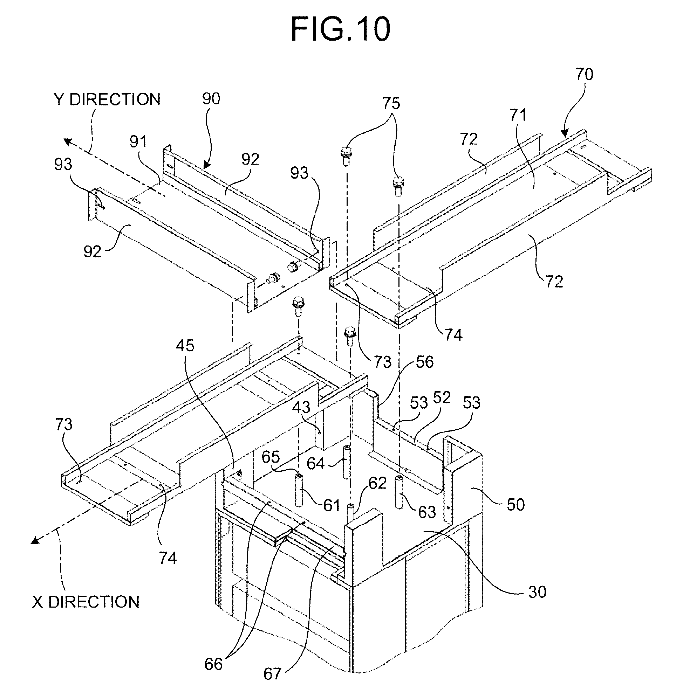

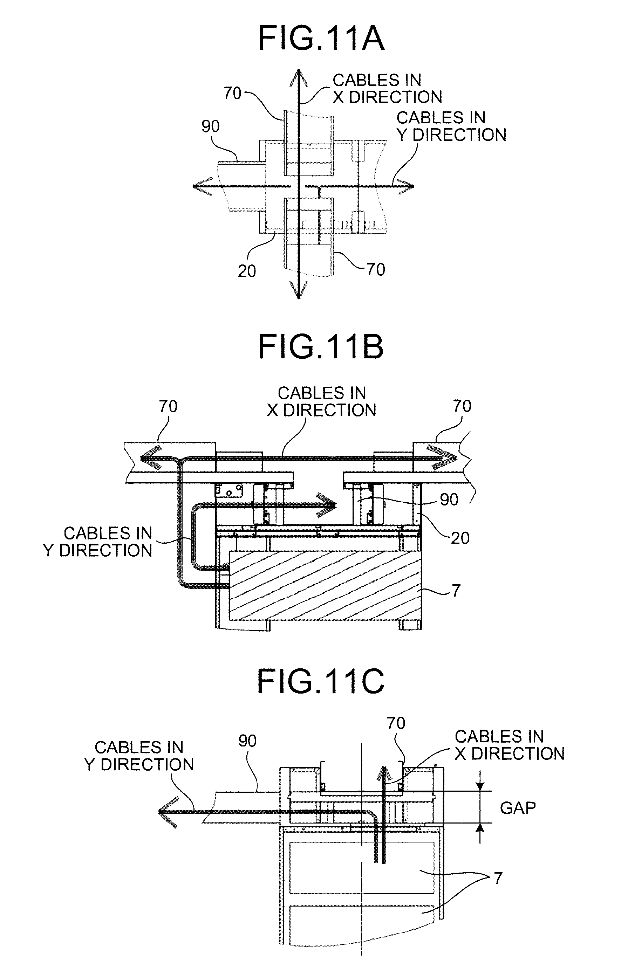

Further, FIG. 10 is a perspective view of a configuration of a cable duct with which bridge plates are provided. FIG. 11A is a top view of an electronic device. FIG. 11B is a side view of the electronic device. FIG. 11C is a cross-sectional view of the cable duct.

In the electronic device system according to the example of the second embodiment depicted in FIG. 7, some of the constituent elements that are the same as those of the housings 2 of the electronic devices 1a and 1b depicted in FIGS. 1 and 2 will be referred to by using the same reference characters, and the detailed explanation thereof will be omitted. Further, in FIGS. 8 to 10 and FIGS. 11A to 11C, the housings forming the electronic devices 1a to 1e are omitted from the drawings.

In the electronic device system according to the second embodiment, when an electronic device at a connection destination is positioned distant from the electronic device 1b used as a reference position, a bridge plate 90 is provided so as to link together the cable ducts 20 of the electronic devices. Further, when the alignment direction of an electronic device at a connection destination is different, a bridge plate 70 is provided so as to link together the two cable ducts 20 having the mutually different alignment directions.

More specifically, FIG. 8 is a drawing for explaining an electronic device system in which a plurality of electronic devices 1a to 1e on which a plurality of (e.g., five in FIG. 8) cable ducts 20 are placed are connected together. As depicted, for the electronic devices 1a to 1e on which the plurality of cable ducts 20 are placed, the bridge plates 70 and 90 for linking and bridging between the cable ducts 20 are used.

As depicted in FIG. 9, each of the cable ducts 20 includes: the bottom plate 30; the first lateral plate 40 and the second lateral plate 50 that are provided so as to stand on two sides of the bottom plate 30; and the rear plate 52 having a pair of screw holes 53 formed therein. Further, a fixed plate 67 that links the first lateral plate 40 and the second lateral plate 50 together and that has a pair of screw holes 66 formed therein is fixed to the front side of the cable duct 20.

An opening 45 with which the fixed plate 68 is provided and that is defined by the first lateral plate 40 and the second lateral plate 50 serves as an opening used when the bridge plate 70 bridges between cable ducts 20. Similarly, a window 56 formed above the rear plate 52 also serves as an opening used when the bridge plate 70 bridges between cable ducts 20. Further, the screw holes 53 provided in the rear plate 52 and the screw holes 66 provided in the fixed plate 67 serve as screw holes used for fixing bridge plates 70.

Further, screw holes 43 and 55 are provided in lower positions on end faces 42 and 54 of the first lateral plates 40 and 50 of the cable duct 20. The screw holes 43 and 55 that are provided on the end faces 42 and 54 of the first lateral plates 40 and 50 serve as screw holes used for fixing the bridge plate 90 to the cable duct 20 by using attachment screws 75.

The bridge plate 70 has a long shape as a whole and includes: a main plate 71 and a pair of lateral plates 72 provided so as to stand on two ends of the main plate 71. Further, insertion holes 73 and 74 configured to have the attachment screws 75 inserted therethrough are provided on two ends of the main plate 71 of the bridge plate 70.

Further, like the bridge plate 70, the bridge plate 90 has a long shape as a whole and includes a main plate 91 and a pair of lateral plates 92 provided so as to stand on two ends of the main plate 91. Further, a pair of insertion holes 93 configured to have the attachment screws 75 inserted therethrough are provided on two ends of the main plate 91 of the bridge plate 90.

As depicted in FIG. 10, to attach the bridge plate 70 to the cable duct 20, the attachment screws 75 inserted through the insertion holes 73 provided in the main plate 71 of the bridge plate 70 are screwed into and fixed to the screw holes 65 in the third pillar 63 and the fourth pillar 64. Similarly, the attachment screws 75 inserted through the insertion holes 74 provided in the main plate 71 are screwed into and fixed to the screw holes 66 provided in the rear plate 52.

Further, the attachment screws 75 inserted through the insertion holes 73 provided in the main plate 71 of the bridge plate 70 are screwed into and fixed to the screw holes 65 in the first pillar 61 and the second pillar 62. Similarly, the attachment screws 75 inserted through the insertion holes 74 provided in the main plate 71 are screwed into and fixed to the screw holes 66 provided in the fixed plate 67. Thus, the bridge plates 70 for an X direction are fixed to the cable duct 20.

Further, as depicted in FIG. 10, to attach the bridge plate 90 to the cable duct 20, the attachment screws 75 inserted through the insertion holes 93 provided in the bridge plate 90 are screwed into and fixed to the screw holes 43 and 55 provided on the end faces 42 and 54 (FIG. 9) of the first and the second lateral plates 40 and 50 of the cable duct 20. Thus, the bridge plate 90 for a Y direction, which is orthogonal with the X direction, is fixed to the cable duct 20.

More specifically, the electronic device 1a that is connected to the electronic devices 1b and 1c positioned adjacent to each other is arranged in a position distant from the electronic devices 1b and 1c. Thus, the cable ducts 20 for the electronic devices 1b and 1c and the cable duct 20 for the electronic device 1a are linked together by the bridge plate 90 (the Y direction).

The bridge plate 90 bridges between the first window 41 in the first lateral plate 40 and the second window 51 in the second lateral plate 50. Also, the cables 9a and 9b from the electronic device 1a and the cables 9a and 9b from the electronic device 1b can be inserted through the bridge plate 90.

In other words, when the electronic devices 1b and 1c are positioned adjacent to each other in mutually the same direction (i.e., the Y direction), while the electronic device 1a at the connection destination is provided in a position distant from the electronic devices 1b and 1c, the bridge plate 90 is provided so as to route a cable path positioned between the cable ducts 20 of the electronic device 1a and the electronic device 1b.

Similarly, with regard to the electronic devices 1a to 1c, the electronic devices 1d and 1e are arranged in distant positions from the electronic device 1b in mutually different directions (the X directions). Thus, the cable duct 20 of the electronic device 1b is linked to the cable duct 20 of the electronic device 1d and to the cable duct 20 of the electronic device 1e by using the bridge plates 70 (the X directions).

The bridge plate 70 bridges between the first window 41 in the first lateral plate 40 and the second window 51 in the second lateral plate 50. Also, the cables 9a and 9b from the electronic device 1a and the cables 9a and 9b from the electronic device 1b can be inserted through the bridge plate 70.

In other words, the bridge plate 70 bridges between the window 56 in the rear plate 52 of the cable duct 20 of the electronic device 1b and the window 56 in the rear plate 52 of the electronic device 1e. Also, the cables 9a and 9b from the electronic device 1b and the cables 9a and 9b from the electronic device 1e can be inserted through the bridge plate 70.

More specifically, when the electronic devices 1d and 1e and positioned in the connection direction (the X direction) that is different from the positional direction (the Y direction) of the electronic device 1b, the bridge plate 90 is provided so as to route the cable path positioned between the cable duct 20 of the electronic device 1b and the cable ducts 20 of the electronic devices 1d and 1e. In this situation, the position in which the bridge plate 70 is attached to the cable duct 20 is higher than the position in which the bridge plate 90 is attached. Thus, there is a gap between the bridge plate 70 and the bridge plate 90.

The cables 9a and 9b drawn from the electronic device 1b are routed through the bridge plate 70 for the X direction positioned in an upper level than the bridge plate 90 and are directed toward the electronic device 1d and the electronic device 1e at the connection destinations. Similarly, the cables 9a and 9b drawn from the electronic devices 1b and 1c are routed through the bridge plate 90 for the Y direction positioned in a lower level than the bridge plate 70 and are directed toward the electronic device 1a at the connection destination.

As explained above, the bridge plates 70 and 90 linked to the cable ducts 20 form the cable paths in the two directions (the X direction and the Y direction) on the mutually different levels (FIG. 11B). Further, because it is possible to cause the cables 9a and 9b drawn from the electronic devices 1a and 1b to intersect each other on the different levels, it is possible to disperse the positional arrangements of the cables 9a and 9b according to the positions of the electronic devices 1a and 1e at the connection destinations.

As explained above, in the electronic device system according to the second embodiment, because the cable duct system including the bridge plates 70 and 90 is used, it is possible to cause the positional arrangements of the cables 9a to 9d to intersect one another on the different levels by using the bridge plates 70 and 90, even if the connection destinations of the cables 9a to 9d provided between the electronic devices 1a to 1e are positioned distant from one another or positioned in the different directions (the intersecting directions). As a result, it is possible to connect the cables 9a and 9b arranged between the electronic devices 1a to 1e while arranging the cables efficiently and in an organized manner.

### <A method for replacing housings in an electronic device system (a first example)>

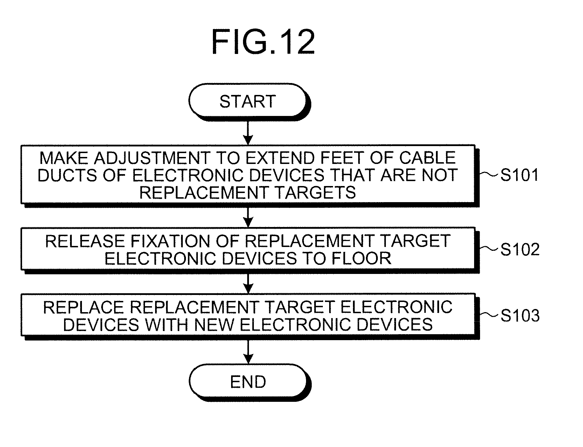

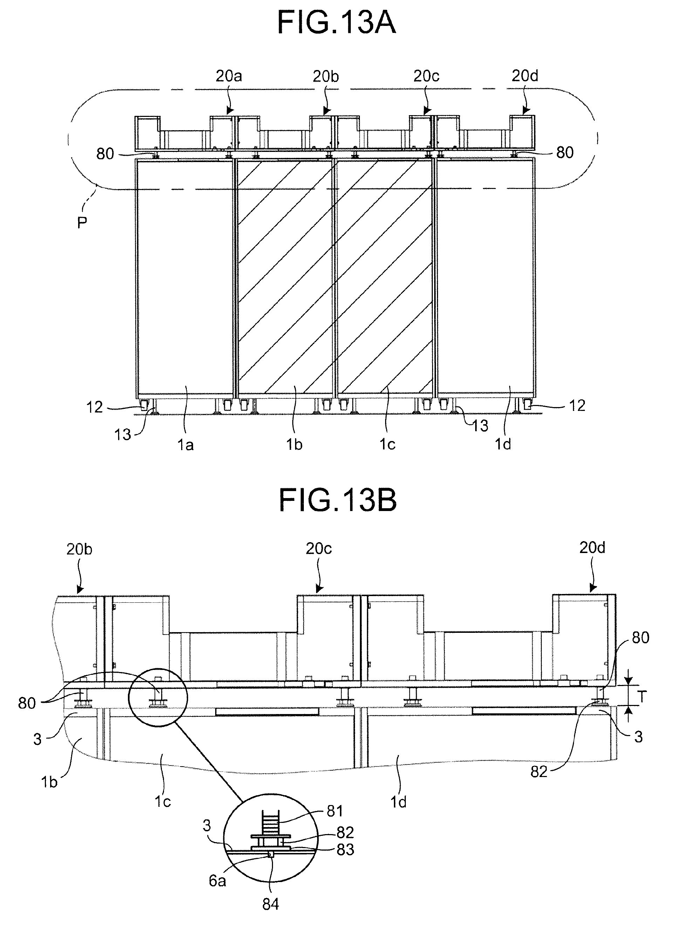

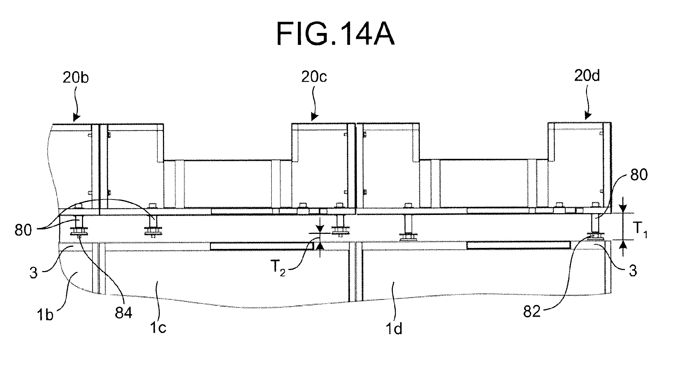

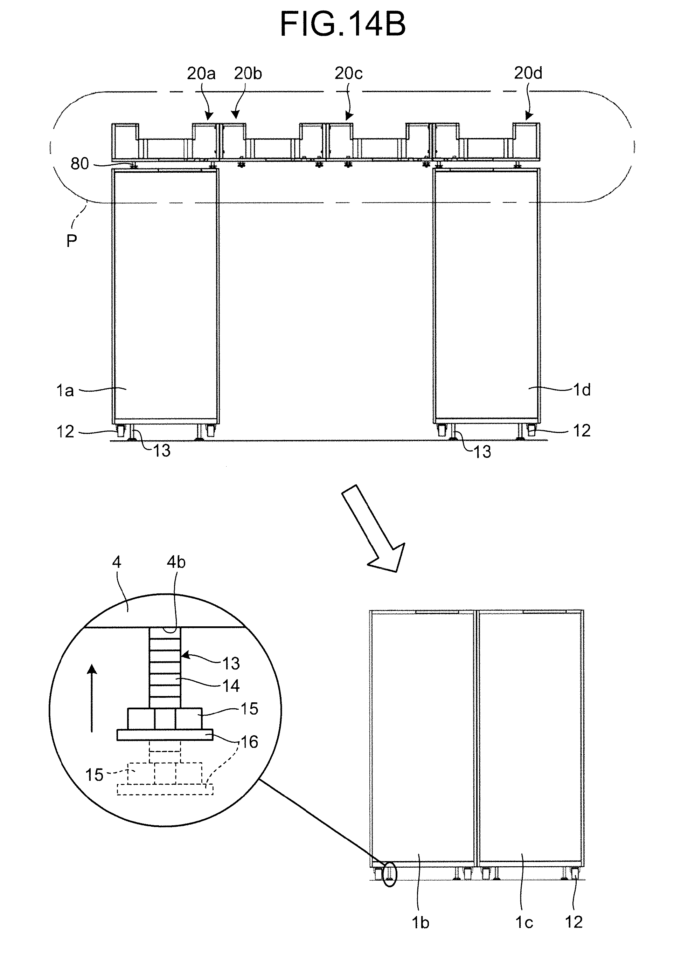

Next, a method (a first example) for replacing housings in an electronic device system will be explained with reference to FIGS. 12, 13A, 13B, 14A, and 14B. FIG. 12 is a flowchart for explaining a procedure in the method for replacing housings in an electronic device system. FIG. 13A is a drawing of a method for replacing electronic devices. FIG. 13B is an enlarged view of the part P in FIG. 13A. FIGS. 14A and 14B are drawings of the method for replacing the electronic devices.

In this situation, with reference to FIGS. 12, 13A, 13B, 14A, and 14B, a replacing procedure will be explained with regard to the four electronic devices 1a to 1d among which the electronic devices 1b and 1c (depicted with hatching) positioned between the electronic device 1a and the electronic device 1d are to be replaced due to failures or the like. Further, the cable ducts 20a to 20d are placed on top of the top plates 3 of the electronic devices 1a to 1d. In the following explanation, it is assumed that the electronic devices 1b and 1c serving as replacement targets are to be replaced manually by human labors or the like.

Specifically, as described in the flowchart of FIG. 12, first, an adjustment is made by extending the feet provided on the cable ducts of the electronic devices that are not the replacement targets (step S101). More specifically, the nuts 82 of the four feet 80 are turned in a predetermined direction, the feet 80 being provided on each of the bottom plates 30 of the cable ducts 20a and 20d placed on top of the electronic devices 1a and 1d that are positioned on either side of the electronic devices 1b and 1c (FIG. 13A). Thus, the height-direction positions of the cable ducts 20a to 20d are raised with respect to the top plates 3 of the electronic devices 1a to 1d.

As explained above, by making the adjustment so as to extend the feet of the cable ducts 20a and 20d of the electronic devices 1a and 1d that are positioned on either side of the electronic devices 1b and 1c and that are not the replacement targets, it is possible to raise the cable ducts 20a to 20d placed on top of the electronic devices 1a to 1d by a predetermined distance.

As a result, the pins 84 (FIG. 13B) of the feet 80 are no longer fitted in the holes 6a provided in the top plates 3 of the electronic devices 1b and 1c. Thus, it is possible to take the pins 84 of the feet 80 out of the holes 6a provided in the top plates 3 of the electronic devices 1b and 1c. As a result, the joining of the electronic devices 1b and 1c to the cable ducts 20b and 20c is eliminated.

In other words, as a result of the adjustment that raises the feet 80 provided on the cable ducts 20 of the electronic devices 1a and 1d, a dimension T (FIG. 13B) of the interval with which the electronic devices 1b and 1c and the cable ducts 20 are fixed is changed to a dimension T₁ (FIG. 14A). Consequently, the joining of the cable ducts 20 to the electronic devices 1b and 1c is eliminated in correspondence with the raised amount of the cable ducts 20 that is equal to a dimension T₂ (FIG. 14A).

Next, the fixation of the replacement target electronic devices to the floor is released (step S102). In other words, an adjustment is made so as to lower the height-direction positions of the raising/lowering feet 13 by turning the nuts 15 (FIG. 14B) in the four raising/lowering feet 13 that are fixed to the bottom plates 4 of the electronic devices 1b and 1c.

More specifically, the electronic devices 1b and 1c are fixed to the floor while being supported by the raising/lowering feet 13. For this reason, by adjusting the nuts 15 (FIG. 14B) and taking the raising/lowering feet 13 off the floor, the fixation of the electronic devices 1b and 1c to the floor is released.

Subsequently, the replacement target electronic devices are replaced with new electronic devices (step S103). More specifically, as depicted in FIG. 14B, the electronic devices 1b and 1c are pulled toward the front from the space between the electronic device 1a and the electronic device 1d, so that the replacement target electronic devices 1b and 1c are replaced with new electronic devices 1a and 1b. In this situation, because the fixation of the electronic devices 1b and 1c to the floor by the raising/lowering feet 13 has been released at step S102, it is possible to move the electronic devices 1b and 1c in a removal direction by moving the wheels 12.

As for the cable ducts 20a to 20d disposed over the electronic devices 1a to 1d, the electronic devices 1a and 1d are joined with the cable ducts 20a and 20d, respectively, even after the electronic devices 1b and 1c are removed. Thus, the cable ducts 20a and 20d are held by the feet 80 in the positions over the electronic devices 1a to 1d.

In this situation, when the electronic devices 1b and 1c to be replaced are actually removed, the cables 9a to 9d connected to the units 7 in the electronic devices 1b and 1c need to be removed. More specifically, first, the connectors (not depicted) of the cables 9a and 9b connected to the two units 7 positioned on the upper levels of the electronic devices 1b and 1c are removed, and the two removed cables 9a and 9b are drawn through the insertion holes 6 provided in the top plates 3.

Also, the two connectors (not depicted) of the cables 9c and 9d connected to the two units 7 positioned on the lower levels of the electronic devices 1b and 1c are removed. Subsequently, the two removed cables 9c and 9d are drawn to the outside of the housings 2 through the insertion holes 4a provided in the bottom plates 4 of the electronic devices 1b and 1c. As a result of this operation, it is possible to remove the electronic devices 1b and 1c provided between the electronic devices 1a and 1d.

The method for replacing the housings in the electronic device system has thus been explained; however, the method is not limited to the procedure described at steps S101 through S103. The steps in the replacing process may be performed partially in parallel or in a reversed order.

According to the method for replacing the housings in the electronic device system explained above, it is possible to easily replace the replacement target electronic devices 1b and 1c that are positioned between the electronic devices 1a and 1d, by performing the simple operation of adjusting the height-direction positions of the feet 80 of the cable ducts 20a to 20d.

Also, in this situation, the cables 9a to 9d are not removed from the electronic devices 1a and 1d, which are not the replacement targets. Thus, only the cables 9a to 9d of the replacement target electronic devices 1b and 1c are removed, and there is no need to remove the cables 9a to 9d of the electronic devices 1a and 1d, which are not the replacement targets. As a result, it is possible to reduce the risk of making wrong connections and having contact failures due to unwanted substances during the cable connecting task and to reduce impacts on the entire system.

### <Another method for replacing housings in an electronic device system (a second example)>

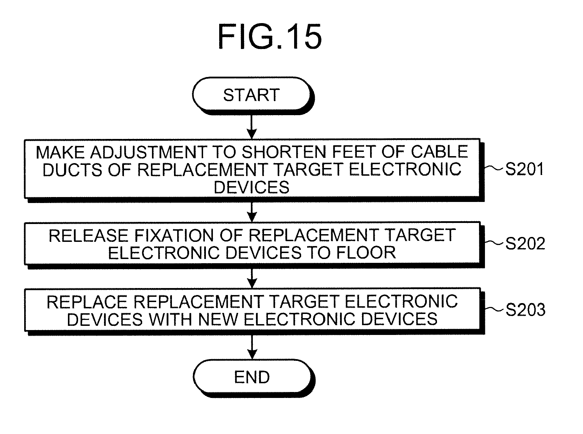

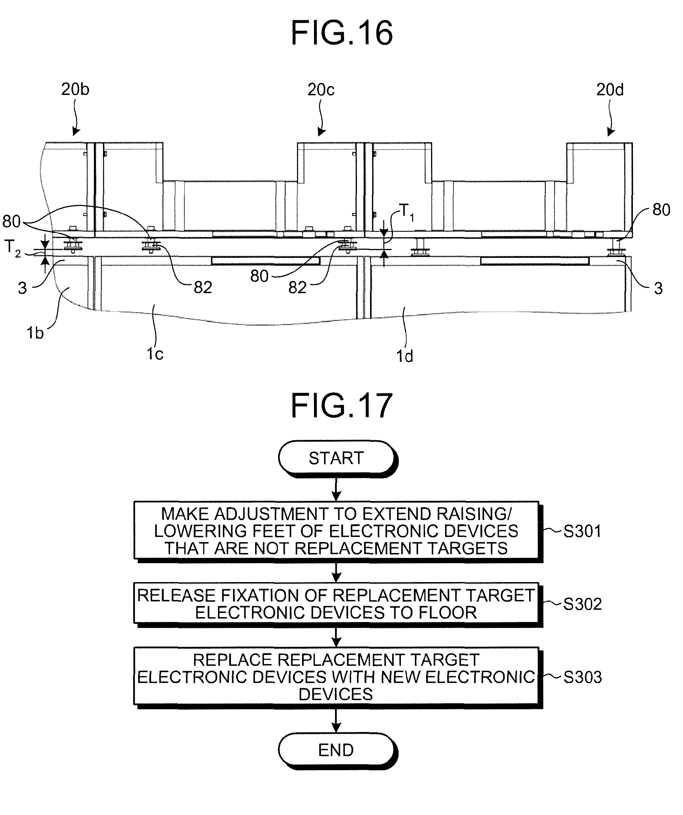

Next, another method (a second example) for replacing housings in an electronic device system will be explained, with reference to FIGS. 15 and 16. FIG. 15 is a flowchart for explaining a procedure in the method for replacing the housings in the electronic device system. FIG. 16 is a drawing for explaining the method for replacing the housings in the electronic device system. In the following explanation, the detailed description of parts of the processing procedure that are the same as those in the first example of the method for replacing the housings in the electronic device system described above will be omitted.

Specifically, as described in the flowchart of FIG. 15, first, an adjustment is made so as to shorten the feet provided on the cable ducts of the replacement target electronic devices (step S201). More specifically, the nuts 82 (FIG. 16) of the four feet 80 are turned in a predetermined direction, the feet 80 being fixed to each of the bottom plates 30 of the cable ducts 20b and 20c placed on top of the electronic devices 1b and 1c. Thus, the height-direction positions of the cable ducts 20b and 20c are lowered with respect to the top plates 3 of the electronic devices 1b and 1c.

By making the adjustment so as to lessen the heights of the feet 80 of the cable ducts 20 of the replacement target electronic devices 1b and 1c in this manner, it is possible to pull out the pins 84 of the feet 80 fitted in the holes 6a provided in the top plates 3 of the electronic devices 1b and 1c. As a result, the joining of the electronic devices 1b and 1c to the cable ducts 20b and 20c is eliminated.

In other words, the adjustment is made so as to lower the feet 80 provided on the cable ducts 20b and 20c of the electronic devices 1b and 1c, among the feet 80 (FIG. 16) of the cable ducts 20a to 20d placed on top of the electronic devices 1a to 1d.

As a result, the dimension T (FIG. 13B) of the interval with which the electronic devices 1b and 1c and the cable ducts 20b and 20c are fixed is changed to the dimension T₁ (FIG. 16). Consequently, the joining of the cable ducts 20 to the electronic devices 1b and 1c is eliminated in correspondence with the raised amount of the cable ducts 20b and 20c that is equal to the dimension T₂. As a result, a space is made available between the replacement target electronic devices 1b and 1c and the cable ducts 20b and 20c so that it is possible to replace the devices.

After that, the fixation of the replacement target electronic devices to the floor is released (step S202). More specifically, in the same manner as in the first example of the replacing method described above, an adjustment is made so as to lower the height-direction positions of the raising/lowering feet 13 by turning the nuts 15 in the four raising/lowering feet 13 that are fixed to the bottom plates 4 of the electronic devices 1b and 1c (FIG. 14B). Thus, the fixation of the electronic devices 1b and 1c to the floor are released.

Subsequently, the replacement target electronic devices are replaced with new electronic devices (step S203). More specifically, in the same manner as in the first example of the replacing method described above, the electronic devices 1b and 1c are pulled toward the front from the space between the electronic device 1a and the electronic device 1d, so that the replacement target electronic devices 1b and 1c are replaced with new electronic devices 1a and 1b.

Like the first example of the replacing method, according to the second example of the method for replacing the housings in the electronic device system described above, it is also possible to easily replace the replacement target electronic devices 1b and 1c, by performing the simple operation of adjusting the height-direction positions of the feet 80 of the cable ducts 20.

Also, in this situation again, there is no need to remove the cables 9a to 9d of the electronic devices 1a and 1d, which are not the replacement targets. In addition, it is possible to reduce the risk of making wrong connections and having contact failures due to unwanted substances during the cable connecting task and to reduce impacts on the entire system.

### <Yet another method for replacing housings in an electronic device system (a third example)>

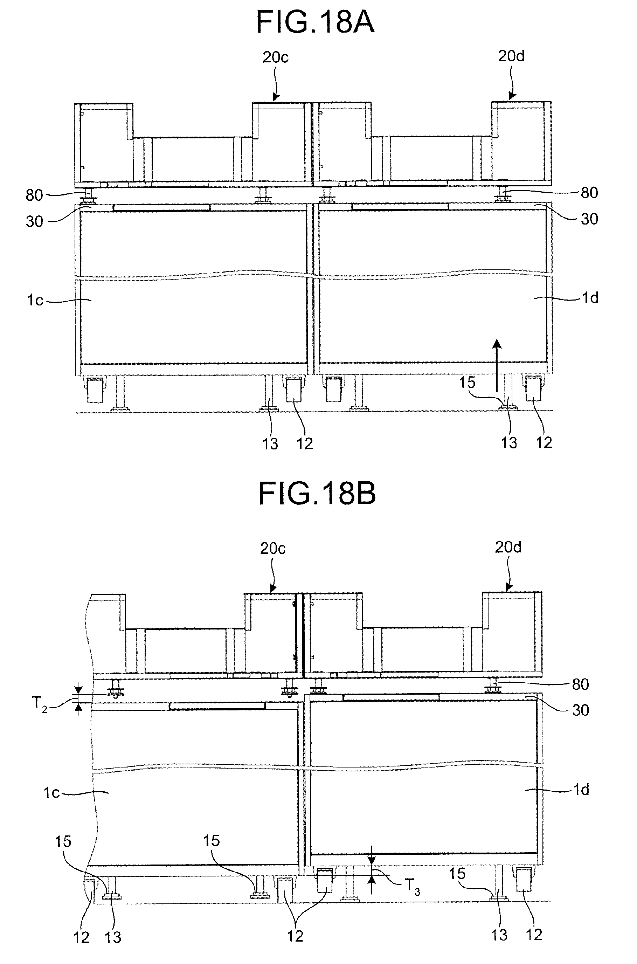

Next, yet another method (a third example) for replacing housings in an electronic device system will be explained, with reference to FIGS. 17, 18A, and 18B. FIG. 17 is a flowchart for explaining a procedure in the method for replacing housings in the electronic device system. FIGS. 18A and 18B are drawings for explaining the method for replacing the housings in the electronic device system.

Specifically, as described in the flowchart of FIG. 17, an adjustment is made so as to extend the raising/lowering feet provided on the bottom plates of the electronic devices that are not the replacement targets (step S301). More specifically, as depicted in FIG. 18A, the nuts 15 (FIG. 14B) of the four raising/lowering feet 13 fixed to the bottom plates 4 of the electronic devices 1b and 1c are turned, so that the height-direction positions of the raising/lowering feet 13 are raised.

Next, the fixation of the replacement target electronic devices to the floor is released (step S302). More specifically, in the same manner as in the first and the second examples of the replacing methods described above, the nuts 15 (FIG. 18B) of the four raising/lowering feet 13 fixed to the bottom plates 4 of the electronic devices 1b and 1c are turned in a predetermined direction. Thus, the adjustment is made so as to lower the height-direction positions of the raising/lowering feet 13. In other words, the fixation of the electronic devices 1b and 1c to the floor is released by adjusting the height-direction positions of the raising/lowering feet 13.

In this situation, because the adjustment is made so as to lower the heights of the raising/lowering feet 13 of the electronic devices 1b and 1c in this manner, the electronic devices 1b and 1c go down by the dimension T₃ (FIG. 18B) in correspondence with the lowering amounts. As a result, a space having the dimension T₂ (FIG. 18B) has been made available, and the pins 84 of the feet 80 are no longer fitted in the holes 6a (FIG. 13B) provided in the top plates 3 of the electronic devices 1b and 1c. Thus, it is possible to remove the electronic devices 1b and 1c.

Subsequently, the replacement target electronic devices are replaced with new electronic devices (step S303). More specifically, in the same manner as in the first and the second examples of the replacing methods described above, the electronic devices 1b and 1c are pulled toward the front from the space between the electronic device 1a and the electronic device 1d, so that the replacement target electronic devices 1b and 1c are replaced with new electronic devices 1a and 1b.

According to the third example of the method for replacing the housings in the electronic device system described above, it is also possible to easily replace the replacement target electronic devices 1b and 1c, by performing the simple operation of adjusting the height-direction positions of the raising/lowering feet 13 of the electronic devices 1a and 1d.

Further, in this situation, there is no need to remove the cables 9a to 9d of the electronic devices 1a and 1d, which are not the replacement targets. Consequently, it is possible to reduce the risk of making wrong connections and having contact failures due to unwanted substances during the cable connecting task and to reduce impacts on the entire system.

According to the method for replacing the electronic devices (the third example) described above, the adjustment is made so as to extend the raising/lowering feet 13 provided on the bottom plates 4, when the electronic devices are to be replaced; however, another arrangement is acceptable in which, when the electronic devices 1a to 1d are installed on the floor, the raising/lowering feet 13 are extended in advance so as to each have a larger height than a reference height, so that the installation is performed while the raising/lowering feet 13 have the increased heights.

More specifically, the adjustment is made so that the positions of the feet 80 of the electronic devices 1a to 1d are at higher levels than the reference positions. Subsequently, in this situation, an adjustment is made so as to lessen the heights of the raising/lowering feet 13 of the replacement target electronic devices 1b and 1c. Thus, the pins 84 of the feet 80 of the cable ducts 20b and 20c are taken out of the holes 6a provided in the top plates 3 of the electronic devices 1b and 1c.

### <Examples of applications to a large-scale system>

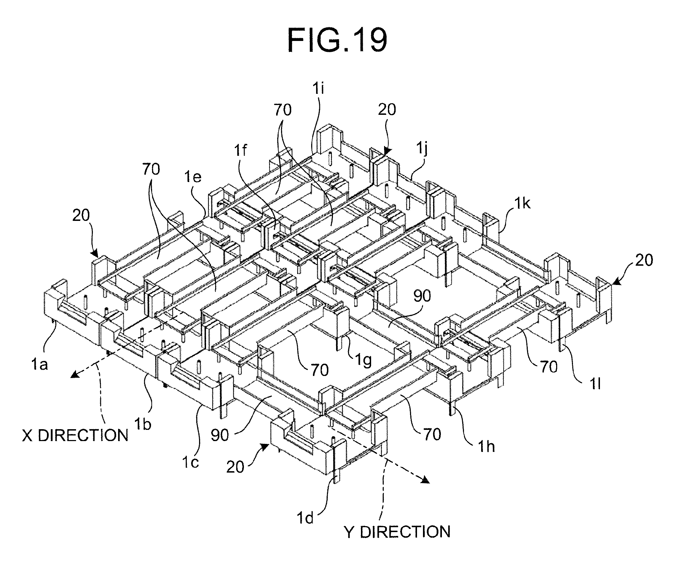

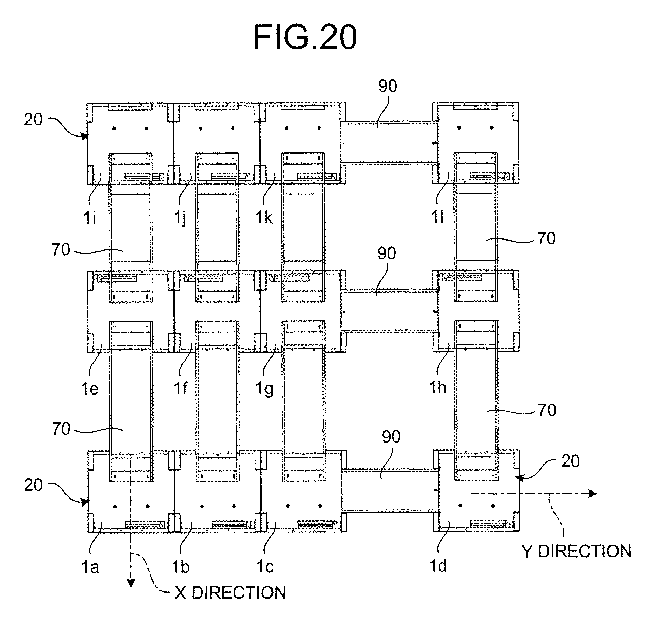

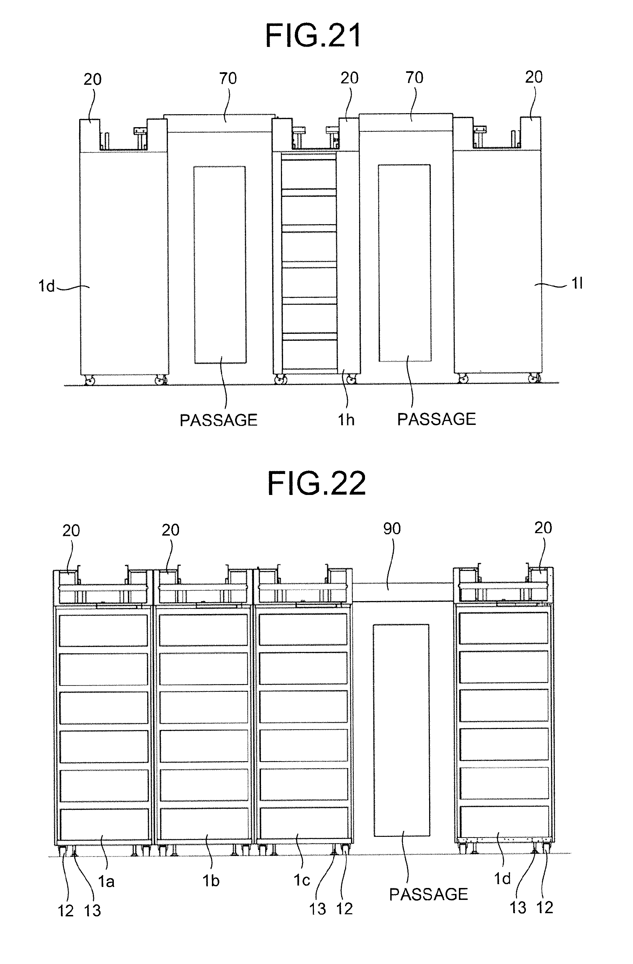

Next, an example in which the electronic device system according to the second embodiment is applied to a large-scale system will be explained, with reference to FIGS. 19 to 22. FIG. 19 is a perspective view of a configuration in which the electronic device system according to the second embodiment is applied to a large-scale system. FIG. 20 is a top view of a configuration of the electronic device system illustrated in FIG. 19. FIG. 21 is a front view of a configuration of the electronic device system illustrated in FIG. 19. FIG. 22 is a side view of a configuration of the electronic device system illustrated in FIG. 19. In FIGS. 19 to 22, the housings forming the electronic devices as well as the cables arranged in the cable ducts are omitted from the drawings.

Specifically, FIGS. 19 and 20 are drawings of an example in which a plurality of electronic devices 1a to 11 on which a plurality of (e.g., twelve in FIGS. 19 and 20) cable ducts 20 are placed are connected together by using a cable duct system. As depicted, with the electronic devices 1a to 11 on which the plurality of cable ducts 20 are placed, it is possible to structure a large-scale electronic device system by using the bridge plates 70 and 90 that link and bridge between the cable ducts 20.

As depicted in FIGS. 19 and 20, the electronic devices 1a to 1c that are positioned adjacent to one another are positioned at a predetermined distance (in a distant position) from the electronic device 1d. Accordingly, the cable ducts 20 of the electronic devices 1a to 1c and the cable duct 20 of the electronic device 1d are bridged by the bridge plate 90 for the Y direction.

Similarly, the electronic devices 1e to 1g that are positioned adjacent to one another are positioned at a predetermined distance from the electronic device 1h. Accordingly, the cable ducts 20 of the electronic devices 1e to 1g and the cable duct 20 of the electronic device 1h are bridged by the bridge plate 90.

Similarly, the electronic devices 1i to 1k that are positioned adjacent to one another are positioned at a predetermined distance from the electronic device 11. Accordingly, the cable ducts 20 of the electronic devices 1i to 1k and the cable duct 20 of the electronic device 11 are linked by the bridge plate 90. The spaces corresponding to the predetermined distance linked by the bridge plates 90 for the Y direction serve as work passages (FIG. 19 to 22) used for performing maintenance inspections and the like.

Further, as depicted in FIGS. 19 and 20, for the electronic devices 1a to 1c, the electronic devices 1e to 1g, and the electronic devices 1i to 1k, which are positioned adjacent to one another, the cable duct 20 of the electronic device 1e is linked to the cable ducts 20 of the electronic device 1a and the electronic device 1i at the connection destinations by the bridge plates 70 for the X direction, while the electronic device 1e is being used as a reference position.

Further, the cable duct 20 of the electronic device 1f is linked to the cable ducts 20 of the electronic device 1b and the electronic device 1j at the connection destinations by the bridge plates 70 for the X direction, while the electronic device 1f among the electronic devices 1e to 1g is being used as a reference position.

Similarly, the cable duct 20 of the electronic device 1g is linked to the cable ducts 20 of the electronic device 1c and the electronic device 1k at the connection destinations by the bridge plates 70 for the X direction, while the electronic device 1g among the electronic devices 1e to 1g is being used as a reference position.

Similarly, the cable duct 20 of the electronic device 1h is linked to the cable ducts 20 of the electronic device 1d and the electronic device 11 at the connection destinations by the bridge plates 70 for the X direction, while the electronic device 1h among the electronic devices 1e to 1g is being used as a reference position. Further, like the bridge plates 90 for the Y direction described above, the spaces corresponding to the predetermined distance linked by the bridge plates 70 for the X direction serve as work passages (FIGS. 19 to 21) used for performing maintenance inspections, repairs, and the like.

As explained above, with the electronic devices for which the bridge plates 70 and 90 are linked to the cable ducts 20 according to the second embodiment, it is possible to connect together the electronic devices that are positioned distant from one another in the X direction or in the Y direction or positioned in mutually different directions from each other, by using the cable duct system. Consequently, it is possible to effectively apply the cable duct system according to the second embodiment to a large-scale electronic device system.

Further, in this situation, it is possible to secure the work passages that are used for performing maintenance inspections, repairs, and the like. Further, it is possible to reduce the man-hours of the entire work required when structuring the electronic device system. As a result, it is possible to introduce an electronic device system in a short period of time and to make an electronic device system operational quickly.

### <Problems with conventional techniques>

FIG. 23 is a drawing of an overview of a conventional electronic device system (a first example). In the conventional electronic device system depicted in FIG. 23, two electronic devices 1a and 1b are linked together. Each of the housings 2 that form the electronic devices 1a and 1b includes the top plate 3, the bottom plate 4, a front cover, and a rear cover (not depicted).

Further, the housing unit 8 in which a plurality of units 7 are installed is provided within the housing 2 of each of the electronic devices 1a and 1b. The plurality of units 7 are connected together by the cables 9. Further, the cable passage 10 having the plurality of cables 9 going therethrough is provided in the housing unit 8.

As depicted in FIG. 23, the cables 9 connected to the units 7 of the electronic device 1a go through the inside of the cable passage 10 and go through the passage 11 provided in the space underneath the floor through the insertion hole 4a provided in the bottom plate 4. Further, the plurality of cables 9 drawn from the inside of the electronic device 1a and going through the passage 11 are each connected to the plurality of units 7 through the cable passage 10 of the electronic device 1b.

As explained above, in the conventional electronic device system, all of the cables 9 connecting together the units 7 between the electronic devices 1a and 1b are configured so as to use the cable passages 10 provided in the electronic devices 1a and 1b, regardless of the positions of the units 7, each of which is positioned on either an upper level or a lower level of the housing units 8.

Further, all of the plurality of cables 9 are configured so as to reach the passage 11 provided underneath the floor by using the cable passages 10. Via the passage 11 provided underneath the floor, the cables 9 are connected to the units 7 after being routed through the cable passage 10 within the electronic device 1b at the connection destination.

Consequently, within each of the electronic devices 1a and 1b, it is preferable to provide the cable passage 10 that is large enough (the dimension L') to allow all the cables 9 to go therethrough. This can be a factor that obstructs the endeavor of configuring the interior of the electronic devices 1a and 1b with a high density.

Further, the total length of the cables 9 themselves is long, and this can make the costs of the component parts expensive, and also, a problem arises where the transmission speed of signal data and the performance level of the entire system become low. Further, another problem arises where the ease of arranging the cables 9 during the cable connecting task is not satisfactory, and this can be a factor that increases the man-hours of the entire work.

FIG. 24 is a drawing of an overview of conventional electronic devices (a second example). In the electronic device system depicted in FIG. 24, three electronic devices 1a to 1c are linked together. Further, like the electronic devices 1a and 1b in the conventional electronic device system described above, each of the housings 2 that form the electronic devices 1a to 1c includes the top plate 3, the bottom plate 4, a front cover, and a rear cover (not depicted).

Further, the housing unit 8 in which a plurality of units 7 are installed is provided within the housing 2 of each of the electronic devices 1a to 1c. The plurality of units 7 are connected together by the cables 9.
Further, the cables 9 connected to the units 7 of the electronic devices 1a to 1c go through the inside of the cable passage 10. Further, after being routed through the passage 11, the cables 9 are each connected to the plurality of units 7 through the cable passages 10 of the electronic devices 1a to 1c.

Consequently, like the electronic device system in the first conventional example, it is preferable to provide the cable passage 10 that is large (the dimension L'), and this can be a factor that obstructs the endeavor of making the density higher. Further, because the total length of the cables 9 is long, problems arise where the costs of the component parts become expensive and where the transmission speed and the performance level of the entire system become low.

### Reference Signs List

- 1a to 11: ELECTRONIC DEVICES
- 2: HOUSING
- 3: TOP PLATE
- 4: BOTTOM PLATE
- 5: FRONT COVER
- 6a: HOLE
- 7: UNIT
- 8: HOUSING UNIT
- 9, 9a, 9b, 9c, 9d: CABLE
- 10: CABLE PASSAGE
- 11: PASSAGE
- 12: WHEEL
- 13: RAISING/LOWERING FOOT
- 14: THREADED PART
- 15: NUT
- 16: DISC PLATE
- 20a, 20b, 20c, 20d: CABLE DUCT
- 30: BOTTOM PLATE
- 31: CUT-OUT PART
- 40: FIRST LATERAL PLATE
- 50: SECOND LATERAL PLATE
- 41: FIRST WINDOW
- 51: SECOND WINDOW
- 61: FIRST PILLAR
- 62: SECOND PILLAR
- 63: THIRD PILLAR
- 64: FOURTH PILLAR
- 61a to 64a: SCREW HOLE
- 70, 90: BRIDGE PLATE
- 73, 74: INSERTION HOLE
- 75: ATTACHMENT SCREW
- 80: FOOT
- 81: THREADED PART
- 82: NUT
- 83: DISC PLATE
- 84: PIN

## Claims

1. A cable duct disposed over a top plate of a housing containing an electronic device, the cable duct comprising:
a bottom plate that has a front side, a first lateral side, a second lateral side, and a rear side and that includes, at the front side, a cut-out part through which a cable from the electronic device is inserted;
a first lateral plate that is provided so as to stand on the first lateral side and that includes a first window through which the cable can be inserted; and
a second lateral plate that is provided so as to stand on the second lateral side and that includes a second window through which the cable can be inserted.

2. The cable duct according to claim 1, further comprising: first to fourth pillars that are provided so as to stand at vertices of a rectangular area on the bottom plate, wherein
the cable from the electronic device routed through the cut-out part is further routed between the first pillar and the second pillar and can be inserted either through the first window after being routed between the second pillar and the third pillar or through the second window after being routed between the first pillar and the fourth pillar.

3. The cable duct according to claim 1, further comprising: a foot that is provided on the bottom plate, is configured so as to be extended and shortened, and can be fitted into a hole provided in the top plate of the housing.

4. An electronic device system comprising:
a first housing that contains a first electronic device;
a second housing that contains a second electronic device and is positioned adjacent to the first housing;
a first cable duct that is disposed over the first housing and routes a cable from the first electronic device; and
a second cable duct that is disposed over the second housing so as to be positioned adjacent to the first cable duct and that routes the cable from the first cable duct to the second electronic device.

5. The electronic device system according to claim 4, wherein
one of the first and the second cable ducts includes:
a bottom plate that has a front side, a first lateral side, a second lateral side, and a rear side and that includes, at the front side, a cut-out part through which a cable from one of the first and the second electronic devices is inserted;
a first lateral plate that is provided so as to stand on the first lateral side and that includes a first window through which the cable can be inserted; and
a second lateral plate that is provided so as to stand on the second lateral side and that includes a second window through which the cable can be inserted.

6. The electronic device system according to claim 4, wherein
the one of the first and the second cable ducts further includes first to fourth pillars that are provided so as to stand at vertices of a rectangular area on the bottom plate, and
the cable from the one of the first and the second electronic devices routed through the cut-out part is further routed between the first pillar and the second pillar and can be inserted either through the first window after being routed between the second pillar and the third pillar or through the second window after being routed between the first pillar and the fourth pillar.

7. The electronic device system according to any one of claims 4 to 6, wherein the one of the first and the second cable ducts includes a foot that is provided on the bottom plate, is configured so as to be extended and shortened, and can be fitted into a hole provided in a top plate of one of the first and the second housings.

8. A cable duct system disposed over top plates of a plurality of housings each of which contains an electronic device, comprising:
a first cable duct that includes:
a first bottom plate that is disposed over the top plate of a first housing containing a first electronic device, has a first front side and a first lateral side, and includes, at the first front side, a first cut-out part through which a cable from the first electronic device is inserted; and
a first lateral plate that is provided so as to stand on the first lateral side and that includes a first window through which the cable from the first electronic device can be inserted;
a second cable duct that includes:
a second bottom plate that is disposed over the top plate of a second housing containing a second electronic device, has a second front side and a second lateral side, and includes, at the second front side, a second cut-out part through which a cable from the second electronic device is inserted; and
a second lateral plate that is provided so as to stand on the second lateral side and that includes a second window through which the cable from the second electronic device can be inserted; and
a first bridge that bridges between the first window and the second window and is configured so that the cable from the first electronic device and the cable from the second electronic device can be inserted therethrough.

9. The cable duct system according to claim 8, further comprising:
a third cable duct that includes:
a third bottom plate that is disposed over the top plate of a third housing containing a third electronic device, has a third front side and a third rear side, and includes, at the third front side, a third cut-out part through which a cable from the third electronic device is inserted; and
a third rear plate that is provided so as to stand on the third rear side and that includes a window through which the cable from the third electronic device can be inserted; and
a second bridge that bridges between a window provided in a first rear plate provided with the first bottom plate of the first cable duct and the window provided in the third rear plate and that is configured so that the cable from the first electronic device and the cable from the third electronic device can be inserted therethrough.

10. The cable duct system according to claim 9 further comprising:
a fourth cable duct that includes: a fourth bottom plate that is disposed over the top plate of a fourth housing containing a fourth electronic device, has a fourth front side, and includes, at the fourth front side, a fourth cut-out part through which a cable from the fourth electronic device is inserted; and
a third bridge that bridges between an opening defined at the first front side of the first cable duct and an opening defined at the fourth front side of the fourth cable duct and that is configured so that the cable from the first electronic device and the cable from the fourth electronic device can be inserted therethrough.

11. The cable duct system according to claim 8, wherein
the first cable duct further includes a first pillar and a second pillar provided so as to stand on the first bottom plate,
the third cable duct further includes a third pillar and a fourth pillar provided so as to stand on the third bottom plate, and
the second bridge is fastened to the first to the fourth pillars.

12. The cable duct system according to claim 10, wherein
the first cable duct further includes a fifth pillar and a sixth pillar provided so as to stand on the first bottom plate,
the fourth cable duct further includes a seventh pillar and a eighth pillar provided so as to stand on the third bottom plate, and
the third bridge is fastened to the fifth to the eighth pillars.

13. A method for replacing a housing in an electronic device system that includes: a first housing containing a first electronic device; a second housing containing a second electronic device; and a third housing containing a third electronic device and being disposed between the first housing and the second housing; a first cable duct being disposed over the first housing and routing a cable from the first electronic device; a second cable duct being disposed over the second housing and routing a cable from the second electronic device; and a third cable duct being disposed over the third housing, being fastened to the first and the second cable ducts, and routing the cable from the first electronic device and the cable from the second electronic device, the method comprising:
taking a foot of the third cable duct out of a hole provided in a top plate of the third housing by extending a foot of the first cable duct fitted in a hole provided in a top plate of the first housing and a foot of the second cable duct fitted in a hole provided in a top plate of the second housing;
releasing a fixation of the third housing to a floor on which the third housing is placed; and
replacing the third housing with a new third housing.

14. A method for replacing a housing in an electronic device system that includes: a first housing containing a first electronic device; a second housing containing a second electronic device; and a third housing containing a third electronic device and being disposed between the first housing and the second housing; a first cable duct being disposed over the first housing and routing a cable from the first electronic device; a second cable duct being disposed over the second housing and routing a cable from the second electronic device; and a third cable duct being disposed over the third housing, being fastened to the first and the second cable ducts, and routing the cable from the first electronic device and the cable from the second electronic device, the method comprising:
taking a foot of the third cable duct out of a hole provided in a top plate of the third housing by shortening the foot of the third cable duct fitted in the hole provided in the top plate of the third housing;
releasing a fixation of the third housing to a floor on which the third housing is placed; and
replacing the third housing with a new third housing.

15. A method for replacing a housing in an electronic device system that includes: a first housing containing a first electronic device; a second housing containing a second electronic device; and a third housing containing a third electronic device and being disposed between the first housing and the second housing; a first cable duct being disposed over the first housing and routing a cable from the first electronic device; a second cable duct being disposed over the second housing and routing a cable from the second electronic device; and a third cable duct being disposed over the third housing, being fastened to the first and the second cable ducts, and routing the cable from the first electronic device and the cable from the second electronic device, the method comprising:
taking a foot of the third cable duct out of a hole provided in a top plate of the third housing by extending a housing raising/lowering foot provided on a bottom of the first housing and a housing raising/lowering foot provided on a bottom of the second housing;
releasing a fixation of the third housing to a floor on which the third housing is placed; and
replacing the third housing with a new third housing.
